# EUROPEAN PATENT APPLICATION

(11) **EP 0 540 993 A1**
(43) Date of publication of application: **12.05.1993**
(21) Application number: 92118381.0
(22) Date of filing: 28.10.1992
(51) Int. Cl.: H01L 29/62, H01L 27/115

(54) **Structure and fabrication of high transconductance MOS field effect transistor using a buffer layer/ferroelectric/buffer layer stack as the gate dielectric**

(30) Priority: 06.11.1991 US 788379
(71) Applicant: RAMTRON INTERNATIONAL CORPORATION, Colorado Springs, Colorado 80921 (US)
(72) Inventor: Argos, George, Jr., Colorado Springs, CO 80906 (US); Kalkur, Thottam S., Colorado Springs, CO 80933 - 7160 (US)
(74) Representative: Buzzi, Franco

(57) **Abstract**

A field effect transistor is formed with its gate electrode (50) separated from the substrate (10) by a dielectric stack formed by a buffer layer (20), a layer of ferroelectric material (30), and a second buffer layer (40). The gate electrode (50) is directly over the second buffer layer (40). Source and drain regions (60, 70) are located in the substrate (10), and an insulating layer (80) and metalization layer (100) can be employed for contacts. A method for forming the same is also disclosed.

## Description

The present invention is directed to a MOS field effect transistor (FET) having a stack, which is comprised of a buffer layer, a layer of ferroelectric material, and a second buffer layer, as the gate dielectric, and a method for forming the same.

Presently, metal-oxide-semiconductor field effect transistors (MOSFETs) use silicon dioxide as the gate dielectric. In these MOSFETs, high transconductance is desired to allow for low voltage operation which limits thermal heating and power dissipation. The transconductance of the transistor can be increased either by decreasing the oxide thickness or by increasing the dielectric constant of the gate insulator. However, the limit of SiO₂ gate dielectric thinning has been reached due to breakdown and tunneling restrictions. For example, breakdown can occur when the SiO₂ thickness goes below 100 Å (10 nm). A voltage then applied across the gate dielectric can damage the SiO₂ and allow current to flow through it. This is due to the high concentration of electric fields across the thin dielectric layer. Tunneling can occur when the dielectric is so thin that electrons can actually pass through the dielectric, negating its utility.

The use of materials with a high dielectric constant, such as a ferroelectric material, as a replacement for SiO₂ as the gate dielectric has been previously explored. See S. Wu, "Memory Retention And Switching Behavior of Metal-Ferroelectric-Semiconductor Transistors", Ferroelectrics, vol. 11, p. 379-383 (1976); K. Sugibuchi et al., "Ferroelectric Field-Effect Memory Device Using Bi₄Ti₃O₁₂ Film", Journal of Applied Physics, vol. 46, No. 7, p. 2877-2881 (July 1975); A. Mansingh et al., "Non-Volatile Memory Behavior of Metal-Ferroelectric (BaTiO₃ film) - Semiconductor (Si) - MFS Devices", IEEE, p. 576-579 (1986). However, during the fabrication of these prior structures having a ferroelectric material as the gate dielectric, interdiffusion can occur between the layer of ferroelectric material and the silicon substrate or the polysilicon conductor. As a result, a low dielectric constant layer is formed in series with the high dielectric constant ferroelectric material. The low dielectric constant layer limits the effect of an applied voltage on the underlying silicon. Therefore, the transconductance of the transistor is low. If a high dielectric constant ferroelectric material could be formed without the low dielectric constant layer, a high transconductance would result.

The use of a high dielectric constant stack comprising a buffer layer and a layer of ferroelectric material as the dielectric in a capacitor is the subject of an invention and patent application entitled Structure and Fabrication of High Dielectric Constant Metal/Dielectric/Semiconductor Capacitor For Use As The Storage Capacitor In Memory Device by the same inventors of this application, George Argos, Jr. and T. S. Kalkur (attorney docket no. RAM 335).

The object of the present invention is to provide a field effect transistor and method of fabrication therefor which does not suffer from the serious drawbacks we have described.

The present invention in one of its aspects is directed to a metal-ferroelectric-silicon field effect transistor (MFSFET) which acts as a high transconductance MOSFET. The gate dielectric of the present invention includes a dielectric stack comprised of a buffer layer, a dielectric layer of ferroelectric material, and a second buffer layer. A gate electrode is located over the dielectric stack.

Source and drain regions are located below and to either side of the dielectric stack. An insulating layer with contact windows, and an overlying metalization layer may be located over the gate electrode for coupling to the gate electrode.

The buffer layers of the present invention inhibit the interdiffusion between the high dielectric constant ferroelectric material and the silicon substrate or polysilicon conductor. The buffer layers prevent the formation of a low dielectric constant layer in series with the ferroelectric material which could result in a low transconductance for the transistor. As a result, the gate insulator stack of the present invention can, in one embodiment, have an effective dielectric constant forty times that of SiO₂. This allows the fabrication of FETs with a lower threshold voltage and higher gain permitting operation at lower voltages. This would then decrease the power dissipation and heating demonstrated by the part, such as an integrated circuit, using the device.

The present invention is further directed to a method for forming a high transconductance FET. In general, the method comprises a sequence of deposition and definition steps to form a dielectric stack comprised of a layer of ferroelectric material sandwiched between two buffer layers. A gate electrode, insulating layer and metalization layer are then established over the dielectric stack.

In describing the preferred embodiment, reference is made to the accompanying drawings wherein like parts have like reference numerals and wherein:
Figure 1 is a cross-section view of a portion of a FET, according to an embodiment of the present invention, showing a first buffer layer over a substrate;
Figure 2 shows the structure of Figure 1 with a layer of ferroelectric material over the first buffer layer;
Figure 3 shows the structure of Figure 2 with a second buffer layer over the layer of ferroelectric material;
Figure 4 shows the structure of Figure 3 after the stack of buffer layers and layer of ferroelectric material has been patterned;
Figure 5 shows the structure of Figure 4 wherein a gate electrode has been added;
Figure 6 shows the structure of Figure 5 wherein the gate electrode has been patterned;
Figure 7 shows the structure of Figure 6 wherein source and drain regions have been implanted in the substrate;
Figure 8 shows the structure of Figure 7 wherein an insulation layer has been added and patterned;
Figure 9 shows the structure of Figure 8 wherein a metalization layer has been deposited and patterned; and
Figure 10 is a plan view of the structure of an embodiment of the present invention.

The method of the present invention comprises a series of fabrication steps which are carried out in the manner set forth below, with reference to a preferred embodiment of using the method.

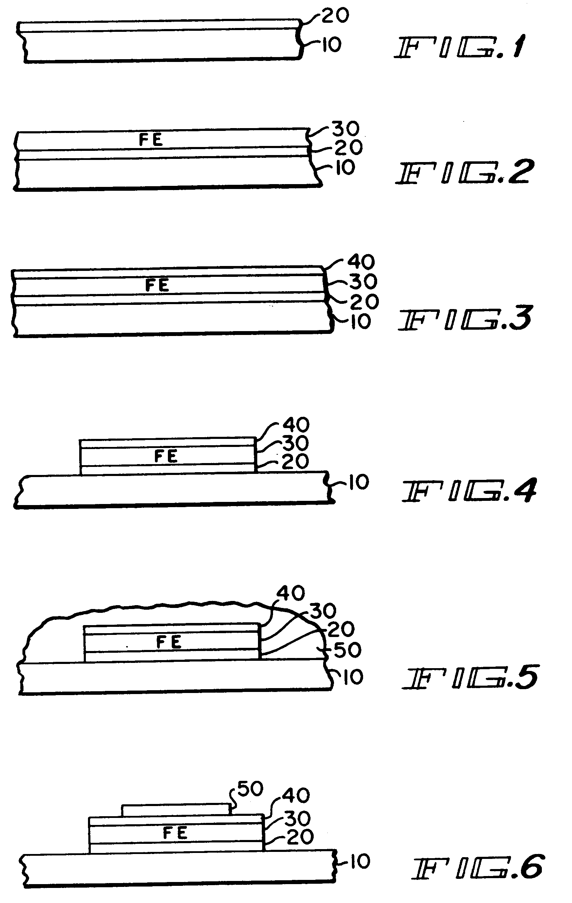

As shown in Figure 1, a substrate 10 is fabricated. Substrate 10 can be fabricated by standard techniques known in the art, and preferably comprises silicon. The silicon may be lightly doped, such as with boron or another p-type dopant. The substrate can also be comprised of GaAs.

In accordance with the present invention, as also shown in Figure 1, a first buffer layer 20 is established directly over substrate 10. Buffer layer 20 can be established by e-beam evaporation, for example. Buffer layer 20 has a thickness of 300 Å (30 nm) and can be comprised of one of the following: ZrO₂, La₂O₃, TiO₂, SiO₂, Bi₂O₃, Nb₂O₅, ThO₂, HfO₂, Ta₂O₅, SnO₂, CeO₃, Y₂O₃, Al₂O₃, MgO₂, Si₃N₄ and MgF₂. Preferably, buffer layer 20 comprises ZrO₂. The thickness of buffer layer 20 can vary depending on what compound layer 20 is comprised of.

A dielectric layer 30 is then established over buffer layer 20, as shown in Figure 2. Preferably, dielectric layer 30 is comprised of a ferroelectric material. The ferroelectric material preferably comprises a lead zirconate titanate composition, called "PZT", having the general formula Pb (ZrₓTi₁₋ₓ) O₃. The Pb (ZrₓTi₁₋ₓ) O₃ stoichiometry can be in the range from x=0 to x=1. Dopants can also be added to the PZT. For example, the PZT can be doped with Ca, La, or other similar materials. Layer 30 can be established by deposition, for example. Deposition can be, for example, by sputtering from a composite oxide target.

A second buffer layer 40 is then established over layer 30, as shown in Figure 3. This layer can be, for example, comprised of similar materials as described above for buffer layer 20 and can be established in a similar manner. However, it need not comprise exactly the same material as buffer layer 20.

Next, the dielectric stack thus formed of layers 20, 30 and 40 is patterned. The stack can be patterned using standard photolithographic techniques and etched in either a wet HF solution, an ion mill, or in a plasma etch. Preferably, the stack is patterned so that the resulting lateral edges of each layer are coincident. Figure 4 shows the results of this step.

The stack is then annealed at a temperature above 500°C in an O₂ ambient in order to convert the PZT to a high dielectric perovskite phase. The annealing can be done by either a rapid thermal anneal or furnace annealing. It is preferred that the stack be patterned before annealing due to adhesion and cracking concerns exhibited during the anneal of a blanket sheet of the stack.

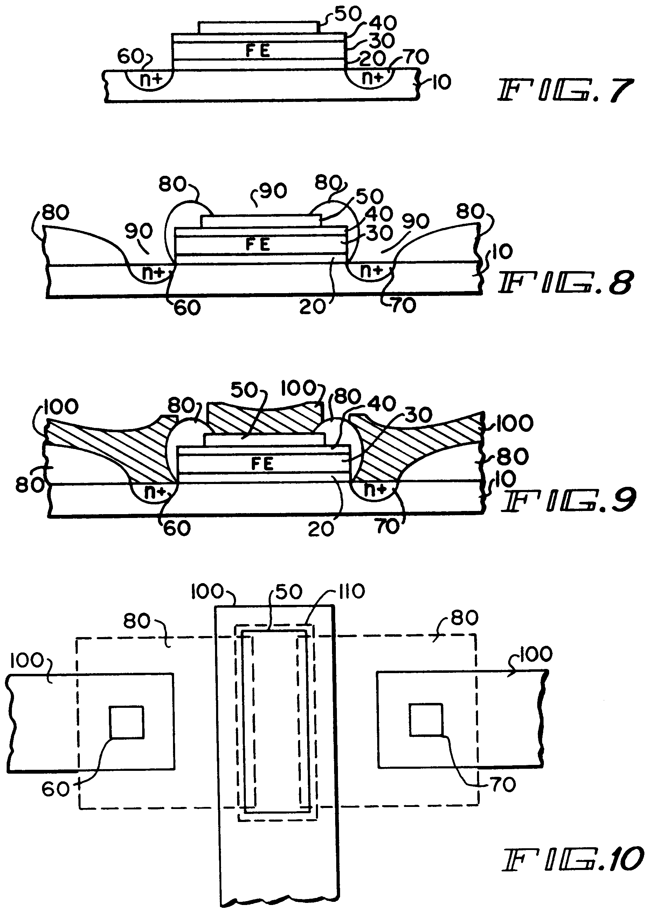

A layer 50* from which a gate electrode 50 will be defined is then deposited, as shown in Figure 5. Gate electrode layer 50* typically is deposited in a thickness of 1,000 Å (100 nm) to 3,000 Å (300 nm). Gate electrode layer 50* is comprised of either polysilicon or a noble metal such as platinum, palladium, or gold, for example. Preferably, the gate electrode is comprised of platinum. If polysilicon is used, it can be doped so as to make it more conductive. The polysilicon can be doped either after being deposited or during the source/drain implantation step, infra. The gate electrode can also be comprised of polycide. Gate electrode layer 50* is then patterned using standard photolithographic techniques and etched by ion milling or plasma etching. The resulting structure now will include a gate electrode 50 as shown in Figure 6. It may be noted that in the preferred embodiment, and as seen in Figure 6, gate electrode 50 is defined with its width narrower than the width of the dielectric stack upon which it rests. This is optional. Gate dielectric 50 could alternatively be made as wide as the stack.

Source and drain regions 60 and 70 are then implanted in the silicon, as shown in Figure 7. Regions 60 and 70 can be defined by a patterning and ion implantation step. In the patterning step, a photoresist (not shown) is established everywhere except in the region to be defined and then standard photolithography techniques can be used to define the region. Ions are then implanted into the substrate in the exposed areas. Standard implantation techniques can be used. Figure 7 shows the resulting structure after the removal of the photoresist. The resulting n+ regions in Figure 7 result from the implantation of phosphorous or arsenic, for example. P+ regions, as shown in Figure 10, can be obtained by implanting boron, for example. The source/drain regions are shown aligned with the lateral edges of the dielectric stack. It will be appreciated that in another modification of the preferred process, the S/D implantation could be done to the structure of Figure 4, after the dielectric stack has been defined, using the stack itself for self-alignment of the inner edges of the S/D implant regions 60 and 70 (prior to any heat driving step).

Returning to the preferred process, an insulating layer 80 is then established, for example by deposition. Layer 80 can be comprised of, for example, silicon dioxide. Layer 80 is then patterned to form contact windows 90 to gate electrode 50 and source and drain regions 60, 70, as shown in Figure 8.

A metalization layer 100 is then deposited over insulating layer 80 and in contact windows 90. Layer 100 can be deposited by, for example, sputtering, CVD, or e-beam evaporation and is comprised of aluminum, for example. Layer 100 is then patterned by standard photolithographic techniques and is etched, either in a wet chemical etch of phosphoric acid, or by plasma etching, to form the desired circuit. A cross-sectional view of the completed structure of the FET of the present invention is shown in Figure 9. In some applications, a contact by layer 100 to the gate electrode may be unnecessary where, for instance, gate electrode 50 is defined as a word line extending along several transistors, as is common in a memory array or subarray. Additionally, contacts to both the source and the drain may be unnecessary in some applications such as DRAM memory cells where one S/D is usually coupled to a capacitor electrode formed adjacent to the transistor. The present invention allows flexibility to designers as to how the electrodes of the invented transistors are to be connected to other circuit elements, and the representation of Figures 8-10 is not a rigid requirement of the invention but rather one illustrative configuration. Others will be apparent to the skilled artisan.

Figure 10 shows a plan view of an embodiment of the structure of the present invention. In this particular embodiment, the source and drain regions 60, 70 are p+ regions.

Thus it will be understood that in the present invention, the gate electrode of a field effect transistor is separated from the underlying substrate by a dielectric stack having a ferroelectric layer with buffer layers above and below the ferroelectric layer. Nothing further is necessary between the gate electrode and the substrate, but further layers could be formed in other modes of practicing this invention.

It is recognized that the FET of the present application can be included within an array of such devices.

This description has been offered for illustrative purposes only and is not intended to limit the invention of this application, which is defined in the claims below.

## Claims

1. A dielectric stack for use in a field effect transistor characterized by substrate (10), a first buffer layer (20) located over said substrate (10), a layer of ferroelectric material (30) located over said first buffer layer (20), and a second buffer layer (40) located over said layer of ferroelectric material (30).

2. The stack of Claim 1 further characterized by said buffer layers (20, 40) being comprised of a compound selected from the group comprising ZrO₂, La₂O₃, TiO₂, SiO₂, Bi₂O₃, Nb₂O₅, ThO₂, HfO₂, Ta₂O₅, SnO₂, CeO₃, Y₂O₃, Al₂O₃, MgO₂, Si₃N₄ and MgF₂.

3. The stack of Claim 1 further characterized by said ferroelectric material being Pb(ZrₓTi₁₋ₓ)O₂ wherein x is in the range of 0 to 1.0.

4. The stack of Claim 1 further characterized by said buffer layers (20, 40) and said layer of ferroelectric material (30) having coincident lateral edges.

5. A field effect transistor characterized by a substrate (10), a first buffer layer (20) located over said substrate (10), a layer of ferroelectric material (30) located over said first buffer layer (20), a second buffer layer (40) located over said layer of ferroelectric material (30), a gate electrode (50) located over said second buffer layer (40), and source (60) and drain regions (70) located in said substrate (10).

6. The field effect transistor of Claim 5 further characterized by said buffer layers (20, 40) being comprised of a compound selected from the group comprising ZrO₂, La₂O₃, TiO₂, SiO₂, Bi₂O₃, Nb₂O₅, ThO₂, HfO₂, Ta₂O₅, SnO₂, CeO₃, Y₂O₃, Al₂O₃, MgO₂, Si₃N₄ and MgF₂.

7. The field effect transistor of Claim 5 further characterized by said ferroelectric material being Pb(ZrₓTi₁₋ₓ)O₂ wherein x is in the range of 0 to 1.0.

8. The field effect transistor of Claim 5 further characterized by said buffer layers (20, 40) and said layer of ferroelectric material (30) have coincident lateral edges.

9. The field effect transistor of Claim 5 further characterized by said gate electrode (50) being comprised of polysilicon.

10. The field effect transistor of Claim 5 further characterized by said gate electrode (50) being comprised of a noble metal.

11. The field effect transistor of Claim 5 further characterized by an insulating layer (80), with contact windows (90), located over said gate electrode (50), and a metalization layer (100) located over said insulating layer and in said contact windows.

12. The field effect transistor of Claim 11 further characterized by said insulating layer (100) having contact windows (90) formed in said insulating layer (100) to said gate electrode (50) and to said source and drain regions (60, 70).

13. A method for fabricating a dielectric stack for a field effect transistor characterized by the steps of forming a substrate (10), establishing a first buffer layer (20) over said substrate (10), establishing a layer of ferroelectric material (30) over said first buffer layer (20), establishing a second buffer layer (40) over said layer of ferroelectric material (30), defining said second buffer layer (40), said layer of ferroelectric material (30) and said first buffer layer (20), and annealing said stack.

14. The method of Claim 13 further characterized by said second buffer layer (40), said layer of ferroelectric material (30) and said first buffer layer (20) being defined so that their lateral edges are coincident.

15. A method for fabricating a field effect transistor characterized by the steps of forming a substrate (10), establishing a first buffer layer (20) over said substrate (10), establishing a layer of ferroelectric material (30) over said first buffer layer (20), establishing a second buffer layer (40) over said layer of ferroelectric material (30), defining said second buffer layer (40), said layer of ferroelectric material (30) and said first buffer layer (20), annealing, establishing and defining a gate electrode (50) over said second buffer layer (40), defining source (60) and drain regions (70) in said substrate (10), establishing and defining an insulating layer (80) with a contact window (90) to an element of the field effect transistor, and establishing a metalization layer (100) over said insulating layer (80) and in said contact window (90).

16. The method of Claim 15 further characterized by said second buffer layer (40), said layer of ferroelectric material (30) and said first buffer layer (20) being defined so that their lateral edges are coincident.
